# EUROPEAN PATENT APPLICATION

(11) **EP 4 510 173 A1**
(43) Date of publication of application: **19.02.2025**
(21) Application number: 23191324.5
(22) Date of filing: 14.08.2023
(51) Int. Cl.: H01L 21/54, H01L 23/24, H01L 23/31, H01L 23/053, H01L 25/07, H01L 23/373

(54) **POWER SEMICONDUCTOR MODULE ARRANGEMENT AND METHOD FOR PRODUCING THE SAME**

(71) Applicant: Infineon Technologies AG, 85579 Neubiberg (DE)
(72) Inventor: WIESEMANN, Markus, 33605 Bielefeld (DE); HERZER, Anita, 67655 Kaiserslautern (DE)
(74) Representative: Westphal, Mussgnug & Partner, Patentanwälte mbB

(57) **Abstract**

A method comprises filling a first material having a first density in a housing, thereby forming a liquid or gel-like first pre-layer, wherein the housing comprises sidewalls, and a substrate with at least one semiconductor body arranged thereon is arranged in or forms a ground surface of the housing, and wherein the first pre-layer partly fills the housing and completely covers the substrate and the at least one semiconductor body arranged thereon, filling a second material being different from the first material and having a second density in the housing, wherein the first density is higher than the second density, thereby forming a liquid or gel-like second pre-layer, wherein the first pre-layer, due to its higher density, forms between the second pre-layer and the substrate, and performing a curing step, thereby simultaneously curing the first material and the second material and forming a solid first layer and a solid second layer, wherein the second layer permanently adheres to the first layer.

## Description

### TECHNICAL FIELD

The instant disclosure relates to a power semiconductor module arrangement and to a method for producing such a power semiconductor module arrangement.

### BACKGROUND

Power semiconductor module arrangements often include at least one substrate. A semiconductor arrangement including a plurality of controllable semiconductor elements (e.g., two or more IGBTs) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. Most power semiconductor module arrangements further include an encapsulant at least partly filling the interior of the housing, thereby covering any components and electrical connections that are arranged on the at least one substrate. The encapsulant is generally configured to electrically insulate areas of different electrical potential within the housing and to protect the components and electrical connections of the power semiconductor module from certain environmental conditions and mechanical damage.

During the use of the power semiconductor module arrangement, heat may be generated. This is due to the high current density of up to 1000 A which is regulated and controlled within the housing, especially in areas with relatively high electrical resistance. In addition, at least some controllable semiconductor elements of the power semiconductor module arrangement perform a plurality of switching operations during the operation of the power semiconductor module arrangement. When performing many switching operations within a short period of time, for example, the controllable semiconductor elements generate heat. Heat that is generated during the operation of the power semiconductor module arrangement is mostly dissipated from the controllable semiconductor elements to the substrate and further through an optional base plate to a heat sink. However, the encapsulant which is in direct contact with the controllable semiconductor elements may also get heated and local hot spots may occur. Due to the heat, over time, the material of the encapsulant may become brittle which may lead to a failure of the power semiconductor module arrangement. The encapsulant, therefore, may comprise at least one thermostable layer directly adjoining the substrate which does not significantly change its physical properties at operating temperatures and does not become brittle during lifetime of the power semiconductor module arrangement, and a mechanically stable upper layer covering the thermostable layer, thereby protecting the thermostable layer and the substrate from certain environmental conditions and mechanical damage.

There is a need for a thermally and mechanically stable power semiconductor module arrangement and for a method which allows to produce such a power semiconductor module arrangement at low costs.

### SUMMARY

A method includes filling a first material having a first density in a housing, thereby forming a liquid or gel-like first pre-layer, wherein the housing includes sidewalls, and a substrate with at least one semiconductor body arranged thereon is arranged in or forms a ground surface of the housing, and wherein the first pre-layer partly fills the housing and completely covers the substrate and the at least one semiconductor body arranged thereon, filling a second material being different from the first material and having a second density in the housing, wherein the first density is higher than the second density, thereby forming a liquid or gel-like second pre-layer, wherein the first pre-layer, due to its higher density, forms between the second pre-layer and the substrate, and performing a curing step, thereby simultaneously curing the first material and the second material and forming a solid first layer and a solid second layer, wherein the second layer permanently adheres to the first layer.

A power semiconductor module arrangement includes a substrate arranged in or forming a ground surface of a housing, the housing including sidewalls, at least one semiconductor body arranged on the substrate, a solid first layer partly filling the housing and completely covering the substrate and the at least one semiconductor body arranged thereon, and a solid second layer arranged adjacent to the first layer, wherein the first layer is arranged between the second layer and the substrate, the first layer comprises or consists of a first material, the second layer comprises or consists of a second material that is different from the first material, and the second layer permanently adheres to the first layer.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of a power semiconductor module arrangement according to embodiments of the disclosure.
Figure 3 is a cross-sectional view of a power semiconductor module arrangement.
Figure 4 schematically illustrates a chemical formula of functionalized polydiorganylsilicones for encapsulants in module assembly.
Figure 5 schematically illustrates a conventional method for forming a multi-layer encapsulant.
Figure 6 schematically illustrates a method for forming a multi-layer encapsulant according to embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connectable pads and includes at least one semiconductor element with electrodes.

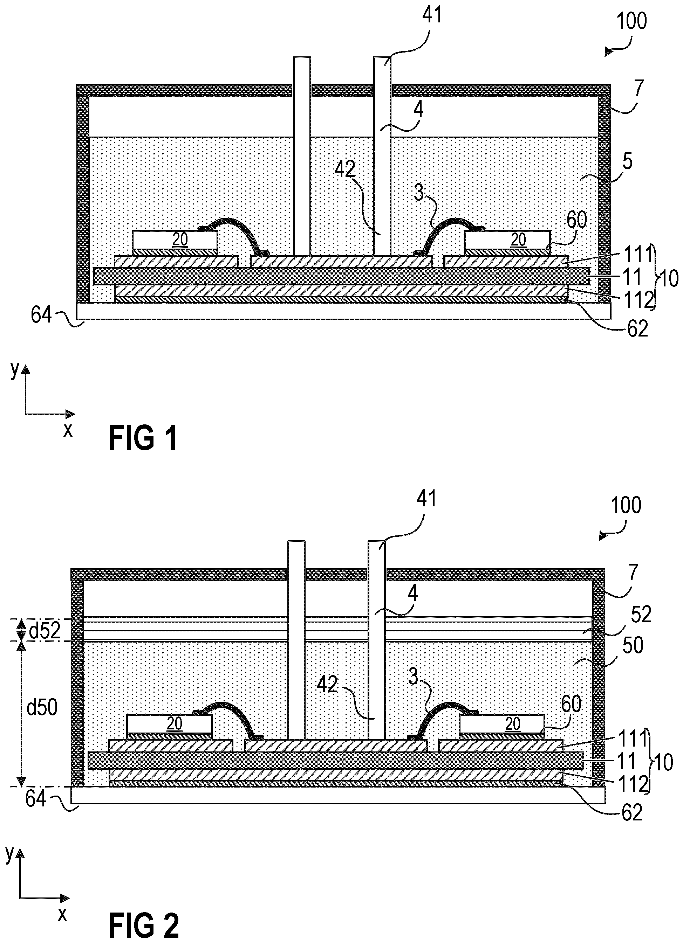

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 64 which forms a base surface of the housing 7, while the housing 7 itself solely comprises sidewalls and, optionally, a top or cover. In some power semiconductor module arrangements 100, more than one substrate 10 is arranged on the same base plate 64 and within the same housing 7. The base plate 64 may comprise a layer of a metallic material such as, e.g., copper or AlSiC. Other materials, however, are also possible. The base plate 64, however, can also be omitted. For example, the substrate 10 itself may form a ground surface of the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted altogether. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example. The one or more substrates 10 may be mechanically and thermally connected to a base plate 64 by means of a connection layer 62. The connection layer 62 may be an electrically insulating adhesive layer, a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 provide an electrical connection between the inside and the outside of the housing 7. The terminal elements 4 may be electrically connected to the first metallization layer 111 with a second end 42, while a first end 41 of the terminal elements 4 protrudes out of the housing 7. The terminal elements 4 may be electrically contacted from the outside at their first end 41.

Arranging the terminal elements 4 centrally on the substrate 10 is only an example. According to other examples, terminal elements 4 may be arranged closer to or adjacent to the sidewalls of the housing 7. The second end 42 of a terminal element 4 may be electrically and mechanically connected to the substrate 10 by means of an electrically conductive connection layer (not specifically illustrated in Figure 1). Such an electrically conductive connection layer may be a solder layer, a layer of an electrically conductive adhesive, or a layer of a sintered metal powder, e.g., a sintered silver (Ag) powder, for example. Alternatively, the terminal elements 4 may also be coupled to the substrate by means of ultrasonic welding.

The power semiconductor module arrangement 100 further includes an encapsulant 5. The encapsulant 5 may consist of or include a cured silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their first ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage. The encapsulant 5 is further configured to electrically insulate areas with different potentials (e.g., different sections of the first metallization layer 111) from each other. Silicone materials that are used to form the encapsulant usually can insulate up to 23.000 V/mm. Silicone materials therefore provide far better insulation properties as compared to, e.g., air, which is able to provide electrical insulation up to about 3.000 V/mm.

During the use of the power semiconductor module arrangement 100, the encapsulant 5 may be heated to a certain degree. This is because at least some semiconductor bodies 20 of the power semiconductor module arrangement 100 generally perform a plurality of switching operations during the operation of the power semiconductor module arrangement 100. When performing many switching operations within a short period of time, for example, the semiconductor bodies 20 generate heat which, in the worst case, may rise to a temperature above a certain maximum threshold. In addition, a high current density of up to 1000 A which is regulated and controlled within the housing, especially in areas with relatively high electrical resistance leads to heat as well. Heat generated during the use of the power semiconductor module arrangement 100 is usually mostly dissipated from the semiconductor bodies 20 to the substrate 10 and further through the (optional) base plate 64 to, e.g., a heat sink (not specifically illustrated). However, a certain amount of heat is always also transferred to the encapsulant 5 which directly contacts the semiconductor bodies 20. The encapsulant 5 usually is a cured silicone layer or a rigid molding compound.

When (repeatedly) exposed to heat over a long period of time (e.g., over the expected lifetime of the power semiconductor module arrangement), the encapsulant 5 degrades thermally and may become brittle or, under certain conditions, liquify. That is, cracks may form in the encapsulant 5, or bubbles caused by evaporating moisture, or partially liquefied and therefore mechanically instable encapsulant 5 may form. In particular, local hot spots may occur in the encapsulant 5 in areas directly adjoining the semiconductor bodies 20. A careful selection of the thermal stability properties of the encapsulant material, typically achieved with heat stabilizing additives, often interferes with other crucial encapsulant properties like its mechanical strength, or with the adhesion ability of the encapsulant 5 to the die 20 or the metallization 111. This trade-off between thermal and mechanical stability, as well as adhesion behavior, must be well balanced and often reduces module lifetime. Often failure mechanisms resulting from these trade-offs are proportional with the thickness of the thermally optimized encapsulant layer, since uprising mechanical forces between the expanding encapsulant 5 next to hot spots and the cool areas adjacent to the housing 7 are higher. Typical failure mechanisms include delaminations of the encapsulant from the die 20, metallization 111, insulating layer 11 or the housing 7 creating air filled areas decreasing the electrical insulation ability of the encapsulant body. Gas bubbles may also form in the material of the encapsulant 5 due to the heat. Such gas bubbles generally arise in areas close to the semiconductor bodies 20 (hot spot areas). As the encapsulant 5 is a cured silicone layer or a rigid molding compound, the gas bubbles cannot move to other areas of the encapsulant 5. The encapsulant 5 may then no longer be able to protect the components and electrical connections of the power semiconductor module 100 from environmental conditions and mechanical damage and reduce the electrical insulation ability of the encapsulant body leading to fatal electrical discharges within the module. An air filled bubble, delamination or crack in the wrong area of the module (e.g. within or close to a recesses between different sections of the first metallization layer 111) may therefore lead to a fatal electrical discharge.

Now referring to Figure 2, a power semiconductor module arrangement 100 according to embodiments of the disclosure is schematically illustrated. The power semiconductor module arrangement 100 generally corresponds to the power semiconductor module arrangement 100 that has been described with respect to Figure 1 above. In the example illustrated in Figure 2, however, the encapsulant comprises two layers, namely a first layer 50 and a second layer 52. The first layer 50 partly fills the housing 7 and completely covers the substrate 10 and the at least one semiconductor body 20 arranged thereon. The second layer 52 is arranged adjacent to the first layer 50 such that the first layer 50 is arranged between the second layer 52 and the substrate 10. The second layer 52 may be arranged distant from a top of the housing 7, for example. That is, an area arranged between the first layer 50 and the top of the housing 7 may only be partly filled with the material of the second layer 52, and a cavity may remain between the second layer 52 and the top of the housing 7. This cavity may be filled with air, for example.

The first layer 50 and the second layer 52 may consist of different materials, thereby providing different properties. For example, the first layer 50 may be a thermostable layer that is able to withstand the high temperatures arising in the power semiconductor module arrangement. The first layer 50, therefore, does not become brittle during the lifetime of the power semiconductor module arrangement. The first layer 50, however, may not be able to protect the substrate 10 and the elements mounted thereon (e.g., the semiconductor bodies 20 and electrical connections 3) from environmental conditions and mechanical damage. Furthermore, the first layer 50 may have a low mechanical strength or adhesion ability, which would lead to delaminations and cracks in the substrate 10 if the module were filled completely, resulting in high mechanical stress within the encapsulant itself and at the interfaces. Protection from environmental conditions and reduction of mechanical stress may be achieved by arranging the second layer 52 on top of the first layer 50. The second layer 52 may be a mechanically stable layer which, however, is not thermostable. This multi-layer structure can also reduce mechanical stress in the thermostable first layer 50 since a mechanically stable and protecting second layer 52 allows a reduction of the thickness of the first thermostable layer 50. Mechanical stress within the encapsulant 5 due to areas of different temperatures is typically proportional to layer thickness. A reduction of the thickness of the mechanically less stable first layer 50 therefore allows a more stable build-up. As the first layer 50 is arranged between the second layer 52 and the substrate 10, however, the second layer 52 is not exposed to the high temperatures arising close to the substrate 10 (i.e. close to the semiconductor bodies 20 arrange on the semiconductor substrate 10). The encapsulant, therefore, is a multi-layer encapsulant comprising at least two layers, wherein each layer serves a different purpose. A thermostable first layer 50 and a mechanically stable second layer 52 are only examples. The different layers may have any specific properties that may be required for a specific power semiconductor module arrangement. Generally, an encapsulant of a power semiconductor module 100 may comprise even more than two layers.

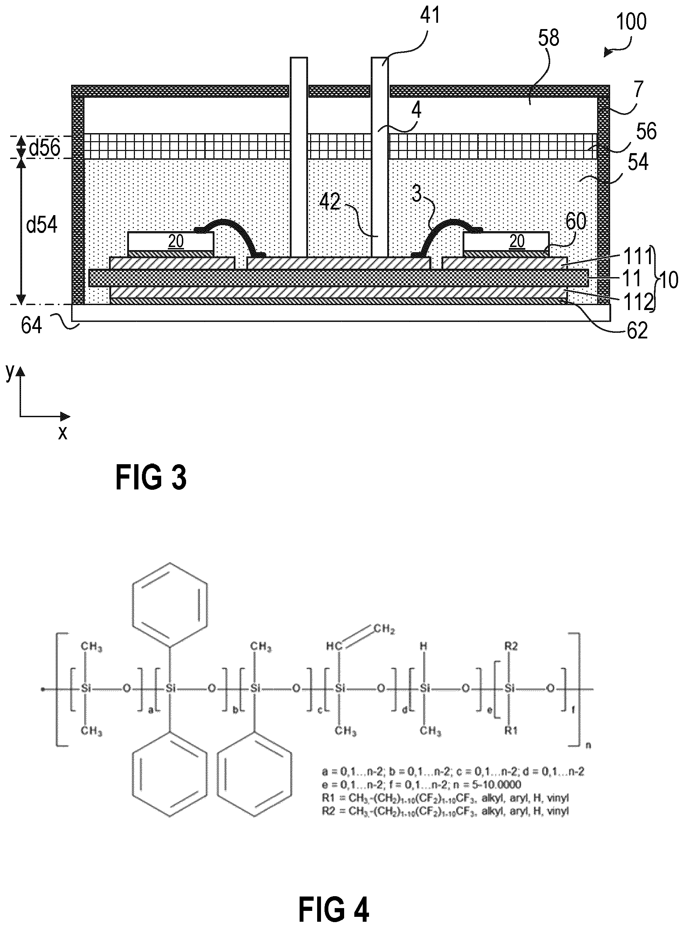

Now referring to Figure 3, a method for forming a power semiconductor module arrangement according to embodiments of the disclosure will be discussed. A method for forming a power semiconductor module arrangement according to embodiments of the disclosure comprises filling a first material having a first density ρ1 in a housing 7, thereby forming a liquid or gel-like first pre-layer 54. The housing 7 comprises sidewalls, and a substrate 10 with at least one semiconductor body 20 arranged thereon is arranged in or forms a ground surface of the housing 7. The first pre-layer 54 partly fills the housing 7 and completely covers the substrate 10 and the at least one semiconductor body 20 arranged thereon. The method further comprises filling a second material being different from the first material and having a second density ρ2 in the housing 7, wherein the first density ρ1 is higher than the second density ρ2, thereby forming a liquid or gel-like second pre-layer 56 consisting of the second material. The first pre-layer 54, due to its higher density ρ1, forms between the second pre-layer 56 and the substrate 10. To guarantee a separation of both miscible phases, the material of the first and/or the second layer may possess a certain viscosity to reduce diffusion and convection during the filling process, and to reduce a storage time to the following curing and fixation steps. This may be a viscosity of the first and/or second layer of at least 450 mPa·s or 2000 mPa·s to limit the convection or diffusion to a local interface area of 1mm for 5 min or 10 min. This can also include less viscous encapsulant materials which would need a more accurate dispensing process and a fast curing/fixation step.

According to one example, the first density ρ1 of the first material is greater than 0.98 g/cm³ at a given temperature, and the second density ρ2 of the second material is less than 0.98 g/cm³ at that given temperature. A difference between the first density ρ1 and the second density ρ2 may be large enough to ensure a complete separation of the first and second material in order to form the two separate pre-layers. For example, a difference between the first density ρ1 and the second density ρ2 may be at least 0.005 g/cm³, or at least 0.1 g/cm³.

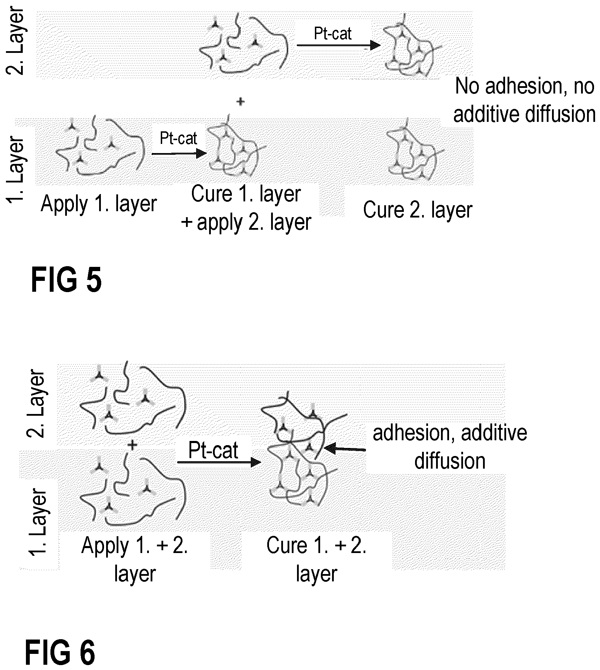

The method further comprises performing a curing step, thereby curing the first material and the second material and forming a solid first layer 50 and a solid second layer 52 simultaneously (see Figure 2). As the method only comprises a single curing step during which the first material and the second material are cured simultaneously, the second layer 52 permanently adheres to the first layer 50. This will be described in further detail with respect to Figures 5 and 6 below. The resulting solid first layer 50 partly fills the housing 7 and completely covers the substrate 10 and the at least one semiconductor body 20 arranged thereon. The first layer 50, due to the higher density of the first material, forms between the substrate 10 and the second layer 52.

The first pre-layer 54 may have a first thickness d54 in the vertical direction y. The resulting first layer 50 may have a second thickness d50 in the vertical direction y which may essentially equal the first thickness d54 or may be somewhat greater than the first thickness d54. This is, because the first material of the first pre-layer 54 may expand to a certain degree when it is heated during the curing step. The second pre-layer 56 may have a third thickness d56 in the vertical direction y, and the resulting second layer 52 may have a fourth thickness d52 in the vertical direction y. The fourth thickness d52 may essentially equal or may be somewhat greater than the third thickness d56, similar to what has been described with respect to the first pre-layer 54 and the resulting first layer 50.

The first layer 50 may have a thickness d50 in the vertical direction y of between 5mm and 20mm (Millimeters), for example. According to one example, a thickness d50 of the first layer 50 is between 12mm and 18mm, e.g., the thickness d50 of the first layer 50 may be 15mm. In this way, there is a sufficient amount of first material to effectively prevent any heat that is generated by the semiconductor bodies 20, for example, from significantly heating the second layer 52. That is, a first layer 50 having a certain thickness d50 may provide an adequate protection for the second layer 52. The thickness d52 of the second layer 52 may equal the thickness of the first layer 50. It is, however, also possible that the thickness d50 of the first layer 50 is greater than the thickness d52 of the second layer 52, as is schematically illustrated in Figures 2 and 3. A smaller thickness d52 of the second layer 52 may be sufficient in order for the second layer 52 to provide sufficient protection for the substrate 10 and the elements mounted thereon from environmental conditions and mechanical damage. The second layer 52 may have a thickness d52 of, e.g., between 3mm and 9mm. According to one example, the thickness d52 of the second layer 52 may be between 5mm and 7mm, e.g., the thickness d52 of the second layer 52 may be 6mm.

The first material and the second material may be filled into the housing 7 simultaneously or successively. The first material and the second material do not essentially mix while being filled into the housing 7. Due to the different densities and viscosities, the first material will descend and form the first pre-layer 54 adjacent to the substrate 10, while the second material rises and forms the second pre-layer 56 on top of the first pre-layer 54. This effect occurs automatically without the need for any further supporting measures.

According to other embodiments of the disclosure, the second material may be filled in the housing 7 first and, in a subsequent second step, the first material may be injected underneath the second pre-layer 56 formed by the second material. In this way, turbulences that may occur in the first and second material during the filling process may be reduced or even avoided. Generally, however, minor mixing effects of the two materials during the filling process vanish within only few seconds, as the materials separate due to the different densities. A single curing step follows. The curing step may comprise heating the power semiconductor module arrangement 100, or at least the first pre-layer 54 and the second pre-layer 56, to temperatures of up to 150°C, for example. It is further possible that a certain amount of pressure is applied during the curing step. The first pre-layer 54 and the second pre-layer 56 can generally also be cured in a single curing step performed at room temperature if the materials that are used to form the first pre-layer 54 and the second pre-layer 56 are designed to cure at lower temperatures.

According to embodiments of the disclosure, the first and second material may each comprise a silicone encapsulant. Pure silicone encapsulants typically comprise a base polymer to an amount of >99 vol%. The silicone material can also comprise fillers to an amount of >80 vol%. Silicone encapsulants may comprise base polymers bearing methyl, phenyl, vinyl, hydrido and partially fluorinated alkyl side-groups as depicted in Figure 4. The average chain length of the polymer n is variable. Low molecular silicones with an averaged molecular weight of 200 g/mol and long chain silicone polymers with an averaged molecular weight of 500.000 g/mol and more are commercially available. The density of the silicone base polymer depends on the substitution pattern and the chain length. Short chained vinylated polymethylsiloxanes (PDMS) show, for example, a low density of 0.90 g/cm³. Increasing molecular weight of polymethylsiloxanes also leads to an increase in density up to 0.98 g/cm³. A partial substitution of methyl with phenyl groups leads to silicone base polymers with densities between 0.95 g/cm³ and 1.11 g/cm³ in dependency of the averaged molecular weight. Fluorination of organic substituents allows to further increase the density of the silicone base polymer to 1.22 g/cm³. In addition to these typical properties of a silicone encapsulant material branching of the silicone polymers influences the density as well. A silicone base polymer can also be copolymerized. For example, a copolymerization with polyacrylates leads to UV-curable silicone encapsulants. The density of copolymerisats is typically in between the densities of the pure polymers. The given densities of typical silicone base polymers are just examples and more variations of the substitution pattern for higher or lower density might be possible. All given densities are typical values at room temperature. The densities might decrease if elevated temperatures are applied.

According to another embodiment of the disclosure, the first and second material may comprise or consist of a first base polymer and a second base polymer mixed with a filler. A filler may be added to increase a density of the base polymer to a desired first density ρ1 of the final silicone ecapsulant mixture. Generally speaking, by adding fillers with densities higher than the silicone base polymer (e.g., SiO₂ TiO₂, Cu, or CaCO₃), the density of the final silicone encapsulant mixture may be increased.

According to embodiments of the disclosure, the density of the first material and the second material can be influenced by mixing the silicone base polymer with solvents possessing densities lower than 0.90 g/cm³, for example, isopropanol (isopropyl alcohol) with a density of 0.79 g/cm³. According to one example, the second pre-layer 56 may comprise between 10 vol% and 30 vol% of isopropanol, e.g. 20 vol% of isopropanol. Isopropanol, however, generally evaporates during the curing step and is no longer present in the cured second layer 52, as the boiling point of isopropanol is only 82 °C.

According to embodiments of the disclosure, a first layer 50 with a first density ρ1 and a second layer 52 with a second lower density ρ2 are formed inside the housing. The densities of the first and second layer 50, 52 can be selected by their silicone base polymer chain length, the substitution pattern of each silicone base polymer and the amount and density of fillers or by mixing the silicone base polymer with low dense solvents. Every combination of these effects can be used to build the two layers within a module. This includes but is not limited to: 1. A first layer 50 comprising a first silicone base polymer with a high averaged molecular weight and therefore high density ρ1, in combination with a second layer 52 comprising the same silicone base polymer substitution but lower averaged molecular weight and lower density ρ2. 2. A first layer 50 comprising a first silicone base polymer with a variable averaged molecular weight and specific density ρ1, and a second layer 52 with a different silicone base polymer with variable averaged molecular weight and a density ρ2, where the density ρ1 is higher than the density ρ2. 3. A first layer 50 comprising a first silicone base polymer with a variable substitution pattern and a variable averaged molecular weight with a high dense filler with a defined density of the mixture ρ1, and a second layer 52 comprising a second silicone base polymer with a variable substitution pattern and a variable averaged molecular weight without a filler and a defined density of ρ2, where the density ρ1 is higher than the density ρ2. 4. A first layer 50 comprising a first silicone base polymer with a variable substitution pattern and a variable averaged molecular weight with a defined density ρ1, and a second layer 52 comprising a second silicone base polymer with a variable substitution pattern and a variable averaged molecular weight mixed with low dense and volatile solvent with a defined density of the mixture ρ2, where the density ρ1 is higher than the density ρ2. The embodiment is also not limited to silicone base polymers and is also applicable for non-silicone polymers like epoxy mold compound. The simultaneous curing is also not limited to thermally induced curing but might also be performed via UV-light or condensation reactions with ambient water. Therefore, the first layer 50 with a defined density ρ1 or the second layer 52 with a defined density ρ2 may be exchanged with a polymer solution or liquid epoxy mold or potting compound where the density ρ1 is higher than the density ρ2.

When cured, the second layer 52 adheres to the first layer 50. This will be described with respect to Figures 5 and 6 in the following. Figure 5 schematically illustrates a conventional method for forming a multi-layer encapsulant. In conventional methods, a first material is filled into the housing to form a first pre-layer. This first pre-layer is then cured to form the first layer. The second material is then filled into the housing on top of the cured first layer and a second curing step is performed. The two resulting layers can be regarded as being entirely separate layers. That is, there is no adhesion between the two cured layers, and the second layer can be pulled off the first layer with comparably low force and without destroying any of the first or the second layer. This may even result in an unwanted delamination of the second layer. This is, because encapsulant materials like silicone gels or epoxy mold compound possess functional chemical groups like vinyl, hydride in case of silicones and epoxy groups within their base polymer backbone or separated in low molecular networker molecules. The materials may also include adhesion promoter molecules typically consisting of mono/di/trialkoxysilyl, mono/di/triacetoxysilyl etc. designed to react with functional groups on different surfaces in order to improve adhesion of the encapsulant material. Those reactive silyl groups may also be connected to the base polymer. These lists of chemically reactive groups must be understood as examples and other functional groups might be used. However, when curing the first pre-layer 54, to a high extend or even all functional groups of any networker and base polymer strains present in the first pre-layer 54 are consumed and the resulting highly networked and solid first layer does only have a minor ability or even no ability to bind to other surfaces in a chemical reaction. During the curing/hardening process of a silicone gel, a Pt-catalyst that is typically present in the respective material connects a networker also present in the material with the base polymer stains. Although the presence of adhesion promoters may allow the resulting first layer to attach to different surfaces during the curing step, its reactivity and concentration is significantly reduced after the curing has been completed. Therefore, it is barely possible to adhere any material to a completely cured (silicone) gel layer.

This is different when the multi-layer encapsulant is formed by means of the method as described herein. As the liquid or gel-like first pre-layer 54 and the liquid or gel-like second pre-layer 56 are cured in one and the same curing step, base polymer stains and networkers of the first material and base polymer stains and networkers of the second material are able to diffuse to the interface between the first pre-layer 54 and the second pre-layer 56. The base polymer stains of the different pre-layers 54, 56 at this interface may permanently attach to each other, thereby permanently adhering the second layer 52 to the first layer 50. That is, base polymer stains of the first pre-layer 54 may coalesce with base polymer stains of the second pre-layer 56 at an interface between the first pre-layer 54 and the second pre-layer 56. The resulting second layer 52 is still separate from the first layer 50, as no mixing of the materials occurs during the curing step. However, the second layer 52 permanently adheres to the first layer 50 and cannot be pulled off from the first layer 50 without destroying the first and the second layer 50, 52.

The described method can be performed in only few steps and is therefore very cost effective, as it can be implemented in a fast and easy way. The resulting power semiconductor module arrangement reduces or avoids that the encapsulant gets brittle over the lifetime of the power semiconductor module arrangement. The reason is that each layer can consist of material with optimized chemical and physical properties for this area. For example a particularly thermostable layer next to the hottest module parts and a mechanically stable second layer. At the same time, the power semiconductor module arrangement is sufficiently protected from certain environmental conditions and mechanical damage. In this way, the lifetime of the power semiconductor module arrangement can be significantly increased. The formation of air bubbles, cracks and delamination in the first and second layers 50, 52 during the curing step may be significantly reduced or even entirely avoided.

## Claims

1. A method comprising:
filling a first material having a first density (ρ1) in a housing (7), thereby forming a liquid or gel-like first pre-layer (54), wherein the housing (7) comprises sidewalls, and a substrate (10) with at least one semiconductor body (20) arranged thereon is arranged in or forms a ground surface of the housing (7), and wherein the first pre-layer (54) partly fills the housing (7) and completely covers the substrate (10) and the at least one semiconductor body (20) arranged thereon,
filling a second material being different from the first material and having a second density (ρ2) in the housing (7), wherein the first density (ρ1) is higher than the second density (ρ2), thereby forming a liquid or gel-like second pre-layer (56), wherein the first pre-layer (54), due to its higher density (ρ1), forms between the second pre-layer (56) and the substrate (10), and
performing a curing step, thereby simultaneously curing the first material and the second material and forming a solid first layer (50) and a solid second layer (52), wherein the second layer (52) permanently adheres to the first layer (50).

2. The method of claim 1, wherein
filling a first material having a first density (ρ1) in a housing (7) comprises filling a first silicone material in the housing (7), and
filling a second material having a second density (ρ2) in the housing (7) comprises filling a second silicone material in the housing (7).

3. The method of claim 1 or 2, wherein the steps of filling the first material in the housing (7) and filling the second material in the housing (7) are performed successively.

4. The method of claim 3, wherein, in a first step, the second material is filled in the housing (7), and, in a subsequent second step, the first material is injected underneath the second pre-layer (56) formed by the second material.

5. The method of any of the preceding claims, wherein the curing step comprises heating at least the liquid or gel-like first pre-layer (54) and the liquid or gel-like second pre-layer (56) to temperatures of up to 150°C.

6. The method of any of the preceding claims, wherein a difference between the first density (ρ1) and the second density (ρ2) is at least 0.005 g/cm3, or at least 0.1 g/cm3.

7. The method of any of the preceding claims, wherein the first material comprises or consists of a first base polymer, and the second material comprises or consists of a second base polymer that is different from the first base polymer.

8. The method of any of claims 1 to 6, wherein the first material comprises or consists of a first base polymer, and the second material comprises or consists of a second base polymer and isopropanol, wherein the isopropanol contained in the second material reduces a density of the second base polymer to a desired second density (ρ2) and evaporates during the curing step.

9. The method of any of claims 1 to 6, wherein the first material comprises or consists of a first base polymer mixed with a filler, and the second material comprises or consists of a second base polymer, wherein the filler increases a density of the first base polymer to a desired first density (ρ1).

10. The method of any of claims 7 to 9, wherein the first base polymer is polymethylphenylsiloxane PPMS, and the second base polymer is polydimethylsiloxane PDMS.

11. The method of any of the preceding claims, wherein the first material has a viscosity of at least 450 mPa·s, or at least 2000 mPa·s, and/or the second material has a viscosity of at least 450 mPa·s, or at least 2000 mPa·s.

12. A power semiconductor module arrangement (100) comprising:
a substrate (10) arranged in or forming a ground surface of a housing (7), the housing (7) comprising sidewalls;
at least one semiconductor body (20) arranged on the substrate (10);
a solid first layer (50) partly filling the housing (7) and completely covering the substrate (10) and the at least one semiconductor body (20) arranged thereon; and
a solid second layer (52) arranged adjacent to the first layer (50), wherein
the first layer (50) is arranged between the second layer (52) and the substrate (10),
the first layer (50) comprises or consists of a first material,
the second layer (52) comprises or consists of a second material that is different from the first material, and
the second layer (52) permanently adheres to the first layer (50).

13. The power semiconductor module arrangement of claim 12, wherein the first layer (50) and the second layer (52) each comprise or consist of a silicone material.

14. The power semiconductor module arrangement of claim 13, wherein the first layer (50) and the second layer (52) are cured silicone layers.

15. The power semiconductor module arrangement of any of claims 12 to 14, wherein the second layer (52) is arranged distant from a top of the housing (7).

## Amended claims

### Amended claims in accordance with Rule 137(2) EPC.

1. A method for producing a semiconductor module arrangement (100), the method comprising:
filling a first material having a first density (ρ1) in a housing (7), thereby forming a liquid or gel-like first pre-layer (54), wherein the housing (7) comprises sidewalls, and a substrate (10) with at least one semiconductor body (20) arranged thereon is arranged in or forms a ground surface of the housing (7), and wherein the first pre-layer (54) partly fills the housing (7) and completely covers the substrate (10) and the at least one semiconductor body (20) arranged thereon,
filling a second material being different from the first material and having a second density (p2) in the housing (7), wherein the first density (ρ1) is higher than the second density (p2), thereby forming a liquid or gel-like second pre-layer (56), wherein the first pre-layer (54), due to its higher density (ρ1), forms between the second pre-layer (56) and the substrate (10), and
performing a curing step, thereby simultaneously curing the first material and the second material and forming a solid first layer (50) and a solid second layer (52), wherein the second layer (52) permanently adheres to the first layer (50).

2. The method of claim 1, wherein
filling a first material having a first density (ρ1) in a housing (7) comprises filling a first silicone material in the housing (7), and
filling a second material having a second density (p2) in the housing (7) comprises filling a second silicone material in the housing (7).

3. The method of claim 1 or 2, wherein the steps of filling the first material in the housing (7) and filling the second material in the housing (7) are performed successively.

4. The method of claim 3, wherein, in a first step, the second material is filled in the housing (7), and, in a subsequent second step, the first material is injected underneath the second pre-layer (56) formed by the second material.

5. The method of any of the preceding claims, wherein the curing step comprises heating at least the liquid or gel-like first pre-layer (54) and the liquid or gel-like second pre-layer (56) to temperatures of up to 150°C.

6. The method of any of the preceding claims, wherein a difference between the first density (ρ1) and the second density (p2) is at least 0.005 g/cm3, or at least 0.1 g/cm3.

7. The method of any of the preceding claims, wherein the first material comprises or consists of a first base polymer, and the second material comprises or consists of a second base polymer that is different from the first base polymer.

8. The method of any of claims 1 to 6, wherein the first material comprises or consists of a first base polymer, and the second material comprises or consists of a second base polymer and isopropanol, wherein the isopropanol contained in the second material reduces a density of the second base polymer to a desired second density (p2) and evaporates during the curing step.

9. The method of any of claims 1 to 6, wherein the first material comprises or consists of a first base polymer mixed with a filler, and the second material comprises or consists of a second base polymer, wherein the filler increases a density of the first base polymer to a desired first density (ρ1).

10. The method of any of claims 7 to 9, wherein the first base polymer is polymethylphenylsiloxane PPMS, and the second base polymer is polydimethylsiloxane PDMS.

11. The method of any of the preceding claims, wherein the first material has a viscosity of at least 450 mPa·s, or at least 2000 mPa·s, and/or the second material has a viscosity of at least 450 mPa·s, or at least 2000 mPa·s.

12. A power semiconductor module arrangement (100) comprising:
a substrate (10) arranged in or forming a ground surface of a housing (7), the housing (7) comprising sidewalls;
at least one semiconductor body (20) arranged on the substrate (10);
a cured solid first layer (50) partly filling the housing (7) and completely covering the substrate (10) and the at least one semiconductor body (20) arranged thereon; and
a cured solid second layer (52) arranged adjacent to the first layer (50), wherein the first layer (50) is arranged between the second layer (52) and the substrate (10), the first layer (50) comprises or consists of a first material,
the second layer (52) comprises or consists of a second material that is different from the first material, and
base polymer stains of the first material at an interface between the first layer (50) and the second layer (52) are permanently attached to base polymer stains of the second material such that the second layer (52) permanently adheres to the first layer (50).

13. The power semiconductor module arrangement of claim 12, wherein the first layer (50) and the second layer (52) each comprise or consist of a silicone material.

14. The power semiconductor module arrangement of claim 13, wherein the first layer (50) and the second layer (52) are cured silicone layers.

15. The power semiconductor module arrangement of any of claims 12 to 14, wherein the second layer (52) is arranged distant from a top of the housing (7).
